Europäisches Patentamt

European Patent Office

Office européen des brevets

(11) Publication number: **0 351 037**
**A1**

## (12) EUROPEAN PATENT APPLICATION

(21) Application number: 89304216.8

(22) Date of filing: 27.04.89

(51) Int. Cl.⁴: **H01L 39/12 , H01L 39/24**

(30) Priority: 15.06.88 US 207170

(43) Date of publication of application:
17.01.90 Bulletin 90/03

(84) Designated Contracting States:
DE FR GB

(71) Applicant: **Corning Glass Works**
**Sullivan Park FR-212**
**Corning New York 14831(US)**

(72) Inventor: **Bardhan, Pronob**
**2 Pinewood Circle**
**Corning New York(US)**
Inventor: **Share, Leroy Steven**
**261 Cutler Avenue**
**Corning New York(US)**
Inventor: **Ketcham, Thomas Dale**
**319 Valley Road**
**Big Flats New York(US)**
Inventor: **Julien, Dell Joseph St.**
**3340 Townsend Road**
**Watkins Glen New York(US)**

(74) Representative: **Smith, Sydney et al**
**Elkington and Fife Beacon House 113**
**Kingsway**
**London WC2B 6PP(GB)**

(54) Fluoride enhanced superconductors.

(57) The properties of a 1,2,3 superconductor ceramic body with a nominal composition of $YBa_2Cu_3O_{7-x}$ are found to be enhanced by the substitution of other anions. In particular the fluoride anion is found to increase the size of the platelets, increase the magnetic flux, and increase the mechanical strength of the body. The fluoride anion is introduced into the 1,2,3 superconductor by any cationic member of the 1,2,3 body.

EP 0 351 037 A1

## FLUORIDE ENHANCED SUPERCONDUCTORS

Superconducting materials are currently playing a prominent role in the recent scientific literature due to the observance of superconductivity at relatively high temperatures. The observation that a $LaBaCuO_x$ ceramic composition could exhibit superconductivity at approximately 30 K has spurred research to find analogues capable of zero resistance conduction at similar or even higher temperatures. That these analogues have been found is a matter of scientific record.

The present invention accepts the nominal operating temperatures that have been achieved above 77 K, the temperature of liquid nitrogen. The invention, herein presented, improves other characteristics associated with superconducting materials. These characteristics are related to the electrical properties, mechanical strength, and ease of fabrication. Importantly, the compositions herein presented can be made to produce large platelet grains that are useful in the production of large grain size, preferentially oriented, polycrystalline bodies with improved current capacity. Larger grain sizes can facilitate commercial use of the superconducting ceramic.

The number of theoretical explanations for how superconductivity has made each recent advance, more than equals the advancing tide of superconductivity innovation. One of several such explanations describes a mechanism in which the oxygen in copper containing superconductors plays an important role. It is postulated that the electronic structure of the oxygen anion influences the subtle forces at play in a zero resistance conductor.

The present invention introduces an alternative anion, fluoride, into the ceramic matrix which is shown to improve certain characteristics of the superconducting ceramic. The fluoride anion may be introduced into the ceramic matrix by any available cationic species contemplated as a constituent of the superconducting ceramic. The present method for manufacturing the superconducting ceramic body has been simplified into a one step firing process.

There are currently several species of superconductors under study in the scientific literature. The improvement herein disclosed is directed to the class of superconductors known as the $YBa_2Cu_3O_{7-x}$ superconducting composition, also known as 1,2,3 superconductors.

### Summary of the Invention

The 1,2,3 superconductors of the present invention consist essentially of a 1,2,3 ceramic body with fluoride additions, comprised of $YBa_2Cu_3O_{7-x}F_y$, wherein stoichiometric proportions of y range from as little as 0.05 up to 4.0 and x ranges from 0 up to 0.5. The source of fluoride may be derived from rare earth fluorides ($REF_3$), such as from combinations with Y, La, Nd, Sm, Eu, Gd, Tb, Dy, Ho, Er, Yb, and/or Lu and a combination thereof. However, fluoride may also be introduced into the ceramic as $CuF_2$, $BaF_2$, or as some combination of $CuF_2$, $BaF_2$ and rare earth fluoride. Other anions, such as sulfur and the other halides, are contemplated as advantageous in the present invention.

In accordance with the invention, there is a method of fabricating the ceramic body wherein $BaCO_3$, $YF_3$, $Y_2O_3$, CuO, and/or $CuF_2$, and/or $BaF_2$ (any of the $RE_2O_3$ and/or $REF_3$ may be appropriately substituted) are mixed as batch materials. The batch is calcined, isostatically pressed, and then sintered.

The fluoride enhanced 1,2,3 ceramic body is found to have improved electrical properties such as lower normal state resistivity, higher electrical superconductive transition, $T_c$, and a superconductive transition that occurs over a narrower temperature range. Fluoride additions improve mechanical properties since the fluoride 1,2,3 ceramic body is less fragile. Furthermore, fluoride loading improves the fabrication capabilities since fluoride assists in the growth of the 1,2,3 phase. The increased growth results in a greater amount of the 1,2,3 phase for comparably made bodies that eschew fluoride.

Large platelike grains from 10 to more than 1000 microns in diameter have been commonly observed in the fluoride enhanced 1,2,3 ceramic bodies. Grains of this size are useful in forming preferentially oriented polycrystalline pieces. Separate high aspect ratio particles which consist of single or multiple grains of 1,2,3 may be obtained by crushing the fluoride laden ceramic bodies. Production of high aspect ratio particles from these bodies is made possible in part by an apparent alteration in the fracture behavior in fluoride containing bodies when compared to nonfluoride containing bodies.

When the high aspect ratio particles of the present invention are placed on a substrate, or example as a slip or in a slurry, the crystalline b axes of the grains become oriented perpendicular to the plane of the substrate. This self-orientation provides bodies containing highly oriented grains of 1,2,3 whereby standard forming methods can be used. Examples of some of the standard forming methods, well known to those in the art, are slip casting, tape casting, pressing or extrusion of slips or slurries which contain the high aspect ratio 1,2,3 particles.

High aspect ratios are important in 1,2,3 superconductors due to anisotropy. This directionality in the current carrying property of a 1,2,3 superconductor requires a preferred alignment for operable conduction. The preferred plane of current flow is perpendicular to the crystalline b axis. High aspect ratio particles provide a means for aligning the preferred direction of current flow with the plane of the substrate.

Magnetic measurements of these high aspect ratio particles exhibit large hysteresis loops, suggestive of enhanced flux pinning. Increased flux pinning indicates that high current carrying capabilities are possible at ambient temperatures (for example, in this case 77K or at liquid nitrogen temperatures). An increase in the current carrying capability may indicate there is a decrease in flux jumping due to the enhanced pinning of the flux. Decreasing flux jumping is important since flux jumping is a major cause of current loss in superconducting material.

The addition of fluoride, as demonstrated in the present invention, improves many of the above cited properties which are known to be problems in the superconductor art.

Brief Description of the Drawings

Fig. 1 exhibits resistivity measurements as a function of temperature of $BaF_2$ doped 1,2,3 superconductors.

Fig. 2 exhibits resistivity measurements as a function of temperature of $BaF_2$ doped 1,2,3 superconductors.

Fig. 3 exhibits resistivity measurements as a function of temperature of $YF_3$ doped 1,2,3 superconductors.

Fig. 4 compares the magnetic hysteresis loop of an $YF_3$ containing and a nonfluoride containing 1,2,3 superconductor.

Fig. 5 compares the magnetic hysteresis loop of a $YF_3$ containing and a nonfluoride containing 1,2,3 superconductor.

Fig. 6 exhibits magnetic hysteresis loops of combinations of $BaF_2$ and $YF_3$ compositions that have been added to 1,2,3 superconductors.

Fig. 7 exhibits x-ray diffraction data of a non-fluoride containing 1,2,3 superconductor.

Fig. 8 exhibits x-ray diffraction data of a fluoride containing 1,2,3 superconductor.

Fig. 9 is an optical micrograph of fluoride containing 1,2,3 superconductors.

Fig. 10 is an optical micrograph of fluoride containing 1,2,3 superconductors exhibiting orientation.

Fig. 11 is a scanning electron micrograph of a fracture section of a $YF_3$ enhanced 1,2,3 superconductor exhibiting cleavage.

Fig. 12 is a scanning electron micrograph of a fracture section of a $YF_3$ enhanced 1,2,3 superconductor exhibiting inclusions.

Description of the Preferred Embodiments

Generally, samples were batched and ball milled with high purity zirconia media in absolute ethanol for four to sixteen hours. The powder was dried and calcined from 800°C to 930°C in air for two to three hours. Small pills were uniaxially pressed, then isostatically pressed at 35 Kpsi and fired between 900°C to 980°C for up to 44 hours in a covered crucible (dense 99.9% alumina). Samples were cooled to room temperature in about 20 hours in an air or oxygen atmosphere. Optionally, samples were then given additional heat treatments of 950°C for 44 hours with a six hour cool to 200°C in oxygen or 450 to 550°C maximum temperature for up to five hours in an oxygen·or air environment. Alternatively, batched powders were vibro-milled dry, calcined at 860°C, ball milled in ethyl acetate, uniaxially pressed and sintered.

To prepare the preferred plurality of high aspect ratio particles from a single batch, the material was pressed and sintered into pills. Subsequently, the pills were lightly ground to give high aspect ratio particles. The resulting particles were sieved to remove the fine particles with diameters of less than 44 micron.

Magnetic hysteresis loops were obtained on a PAR vibrating sample magnetometer adapted with a Kepko bipolar power supply. Samples were cooled to near 65K in the initial field of 0T. Temperatures were measured using gold-iron thermocouples referenced to liquid nitrogen. The field was increased from 0T to .1T, decreased through 0T to the opposite polarity field to negative .1T. The field was again increased to complete the hysteresis loop. The magnetometer was standardized using $MgF_2$ at room temperature as the standard. The volume percent superconductor was calculated by comparing the initial slope of the hysteresis loop with the perfect volume diamagnetism $(-1/4\pi)$ expected for a superconductor.

In order to make the electrical measurements the surfaces of the fired pills were ground by hand on SiC grinding paper. Subsequently, four stripes of gold were evaporated onto the surfaces. Silver epoxy was used to attach copper leads to the samples. The electrical conductivity was measured as a function of temperature using four probe measurements and a total current of up to 0.1 amps. The nominal resistivity was calculated by the physical dimensions of the samples, by assuming that the samples were fully dense and of a single conductive phase. The strength of the material was assessed qualitatively by how easily the samples broke during handling. Phases were assessed qualitatively by optical microscopy in both calcined powder and fired samples. Some compositions were examined with SEM and by magnetization as a function of temperature. X-ray diffraction measurements were taken to determine the presence of the 1,2,3 superconductor.

Table I exhibits the stoichiometric proportions of Examples 1, 2, 3, and 4. The Examples differ by the amount of fluoride present in the 1,2,3 ceramic body. The fluoride present in these samples was derived from yttrium fluoride.

TABLE I

| Example | Composition | Comments |
|---------|-------------|----------|
| 1 | $YBa_2Cu_3O_{7-x}F_{0.5}$ | 1,2,3 type phase major phase large grains |
| 2 | $YBa_2Cu_3O_{7-x}F$ | 1,2,3 type phase major phase large grains |
| 3 | $YBa_2Cu_3O_{7-x}F_2$ | multiphase |
| 4 | $YBa_2Cu_3O_{7-x}F_3$ | multiphase |

Table II exhibits the stoichiometric proportions of samples where the fluoride is derived from $BaF_2$.

TABLE II

| Examples | Composition |
|----------|-------------|
| 5 | $YBa_2Cu_3O_{7-x}F_{0.5}$ |
| 6 | $YBa_2Cu_3O_{7-x}F_{1.0}$ |
| 7 | $YBa_2Cu_3O_{7-x}F_{2.0}$ |
| 8 | $YBa_2Cu_3O_{7-x}F_{3.0}$ |
| 9 | $YBa_2Cu_3O_{7-x}$ |
| 10 | $YBa_2Cu_3O_{7-x}F_{0.05}$ |
| 11 | $YBa_2Cu_3O_{7-x}F_{0.5}$ |
| 12 | $YBa_2Cu_3O_{7-x}F_{2.0}$ |
| 13 | $YBa_2Cu_3O_{7-x}F_{4.0}$ |

Table III exhibits the stoichiometric proportions of the ceramic body wherein the fluoride is derived from a combination of $BaF_2$ and $YF_3$.

TABLE III

| Example | Composition | Comments |
|---------|-------------|----------|
| 14 | $YBa_2Cu_3O_{7-x}F_{1.0}$ | $F_{.9}$ from $YF_3$ |
| 15 | $YBa_2Cu_3O_{7-x}F_{1.0}$ | $F_{.75}$ from $YF_3$ |
| 16 | $YBa_2Cu_3O_{7-x}F_{1.0}$ | $F_{.50}$ from $YF_3$ |
| 17 | $YBa_2Cu_3O_{7-x}F_{1.0}$ | $F_{.1}$ from $YF_3$ |

Table IV exhibits the stoichiometric proportions of samples where the fluoride is derived from $YF_3$.

TABLE IV

| Example | Composition |
|---------|-------------|
| 18 | $YBa_2Cu_3O_{7-x}$ |
| 19 | $YBa_2Cu_3O_{7-x}F_{0.05}$ |
| 20 | $YBa_2Cu_3O_{7-x}F_{0.10}$ |
| 21 | $YBa_2Cu_3O_{7-x}F_{0.25}$ |
| 22 | $YBa_2Cu_3O_{7-x}F_{0.5}$ |

Table V exhibits the stoichiometric proportions of samples where the fluoride is derived rom $CuF_2$. These samples were sintered in oxygen at 958 °C for twenty hours in a crucible enclosure, then slow cooled over 15 hours to room temperature in oxygen with the crucible covering removed.

TABLE V

| Example | Composition |
|---------|-------------|
| 23 | $YBa_2Cu_3O_{7-x}F_{0.5}$ |
| 24 | $YBa_2Cu_3O_{7-x}F_{1.0}$ |
| 25 | $YBa_2Cu_3O_{7-x}F_{2.0}$ |

The examples in Table I were sintered at about 950 °C for twenty hours in oxygen with an additional heat treatment at 950 °C for 44 hours with a 6 hour cool to 200 °C in oxygen. The Examples 5-8 in Table II were sintered at about 950 °C for twenty hours in oxygen with an additional heat treatment at 950 °C for 44 hours with a 6 hour cool to 200 °C in oxygen. Examples 9-13 in Table II were sintered at 950 °C in oxygen for 20 hours with a 20 hour cool to room temperature in oxygen. The examples in Table III exhibit the stoichiometric proportions of samples whereby fluoride is derived from a combination of $BaF_2$ and $YF_3$. These examples were sintered in oxygen at 950 °C for twenty hours. After grinding slightly with a mortar and pestle, an additional heat treatment was performed at 500 °C for about five hours in oxygen. Table IV exhibits the stoichiometric proportions of samples whereby the fluoride is derived from $YF_3$. The examples were sintered in oxygen at 950 °C for twenty hours, with a hold for three hours at 500 °C in oxygen.

Two additional examples were bathed and sintered. The first, Example 26, had a nominal composition of $GdBa_2Cu_3O_{7-x}F_{1.0}$. The batch components were derived from $Gd_2O_3$, $GdF_3$, $BaCO_3$, and $CuO$, sintered at approximately 950 °C for twenty hours, crushed, and heat treated at 500 °C for five hours in oxygen. One additional example, Example 27, was batched and sintered whereby the fluoride was derived from $YF_3$. The Example was sintered at 950 °C for 20 hours in oxygen. After a slight grinding an additional heat treatment was added at 925 °C for several hours in oxygen and at 450 °C for several hours in oxygen.

TABLE VI

| Examples Using BaF$_2$ in Batch, Sintered at 950°C in Oxygen for 20 hours. | | | | | |
|---|---|---|---|---|---|
| Examples | Intensity Relative to 1,2,3 Peak Height | | | | |
| | 1,2,3 | CuO | BaF$_2$ | Y$_2$BaCuO$_5$ | |
| | 3.88 | 2.52 | 3.09 | 2.98 | (d Å) |
| 9 | 1.0 | 0 | 0 | .65 | |
| 10 | 1.0 | 0 | .1 | .21 | |
| 11 | 1.0 | .07 | .21 | .14 | |
| 12 | 1.0 | 1.76 | 1.79 | 2.31 | |
| 13 | No 1,2,3 present; CuO, BaF$_2$ and Cu$_2$Y$_2$O$_5$ present | | | | |

TABLE VII

| Example | Intensity Relative to 1,2,3 Peak Height | | | | |
|---|---|---|---|---|---|
| | 1,2,3 | CuO | BaF$_2$ | Y$_2$BaCuO$_5$ | |
| | 3.88 | 2.52 | 3.09 | 2.98 | (d Å) |
| 5 | 1.0 | .28 | .23 | .30 | |
| 6 | 1.0 | 2.68 | 1.19 | 1.94 | |
| 7 | 1.0 | 3.39 | 1.14 | 2.61 | |
| 8 | No 1,2,3 present; CuO, BaF$_2$ and Y$_2$BaCuO$_5$ present | | | | |

TABLE VIII

| Example | Intensity Relative to 1,2,3 Peak Height | | | | |
|---|---|---|---|---|---|
| | 1,2,3 | CuO | BaF$_2$ | Y$_2$BaCuO$_5$ | |
| | 3.88 | 2.52 | 3.09 | 2.98 | (d Å) |
| 1 | 1.0 | .08 | .09 | .36 | |
| 2 | 1.0 | .20 | .14 | .67 | |
| 3 | 1.0 | 2.35 | 1.00 | 2.06 | |
| 4 | 1.0 | 2.50 | 1.61 | 1.89 | |

TABLE 1X

| Example | Intensity Relative to 1,2,3 Peak Height | | | | |
|---|---|---|---|---|---|
| | 1,2,3 | CuO | $BaF_2$ | $Y_2BaCuO_5$ | |
| | 3.88 | 2.52 | 3.09 | 2.98 | (d Å) |
| 14 $F_{.9}$ from $YF_3$ | 1.0 | .50 | .24 | .45 | |
| 15 $F_{.75}$ from $YF_3$ | 1.0 | .75 | .47 | .94 | |
| 16 $F_{.5}$ from $YF_3$ | 1.0 | .60 | .56 | 1.25 | |
| 17 $F_{.1}$ from $YF_3$ | 1.0 | .34 | 1.53 | .77 | |

Table X lists the volume percent superconductor for samples batched with $CuF_2$ as measured by the degree of magnetic flux exclusion.

TABLE X

| Example | Composition | Volume % Superconductor |
|---|---|---|
| 23 | $Y_1Ba_2Cu_3O_{7-x}F_{0.5}$ | 48 |
| 24 | $Y_1Ba_2Cu_3O_{7-x}F_1$ | 53 |
| 25 | $Y_1Ba_2Cu_3O_{7-x}F_2$ | 2 |

Table XI exhibits the relative line intensities of x-ray powder diffraction patterns for a typical non-fluorine containing 1,2,3 powder and for $Y_1Ba_2Cu_3O_{7-x}F$ (Example 27) batched with $YF_3$.

TABLE XI

| Miller Index* | Relative Intensities | | Designation |
|---|---|---|---|
| | Example 27 | Typical 1,2,3 | |
| 020 | 3 | 4 | A |
| 001, 030 | 22 | 16 | B |
| # | | | |
| 021, 120 | - | 4 | |
| 130, 110 | 4 | 100 | D |
| 041, 140, 050 | 64 | 18 | E |
| 131 | - | 25 | F |
| 002, 060 | 100 | 22 | G |
| 200 | - | 7 | H |
| 151 | 2 | 4 | |
| 122, 221, 070 | 16 | 2 | I |
| 161, 132 | 5 | 21 | J |

* The indexing scheme used designates the long axis as the b axis.
- Indicates line not discerned by computer program used.
# This line is due to $BaF_2$.

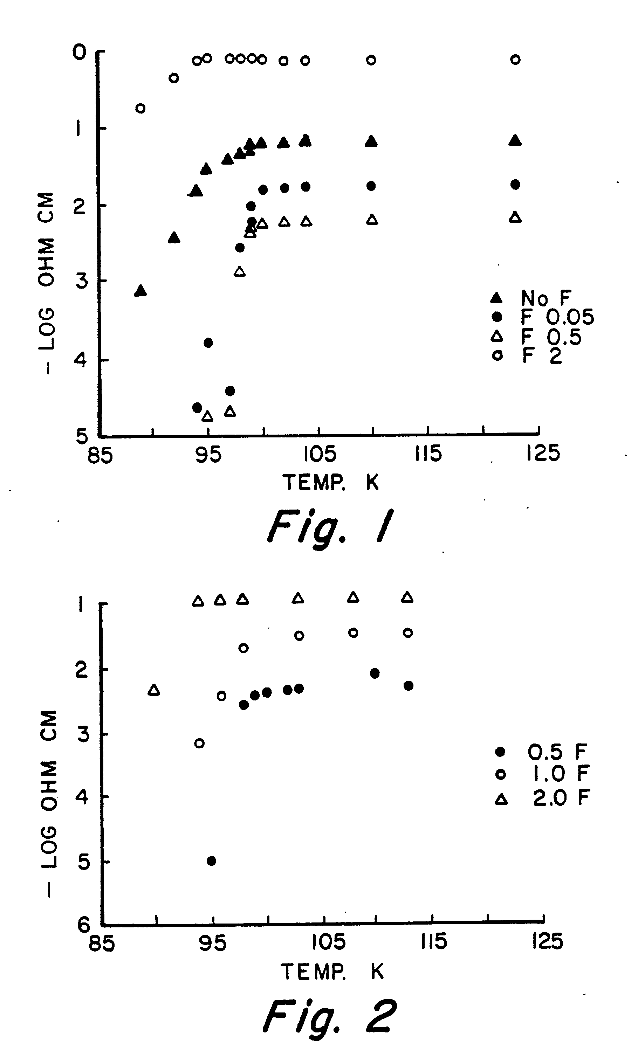

Examples 9-12 batched with $BaF_2$ had electrical resistivity behavior as shown in Fig. 1. Examples 8 and 13 exhibited resistance measurements indicative of an insulator. The addition of the fluoride up to at least a 0.5 stoichiometric amount decreased the normal state resistivity, increased the $T_c$ and narrowed the temperature range for the superconductive transition.

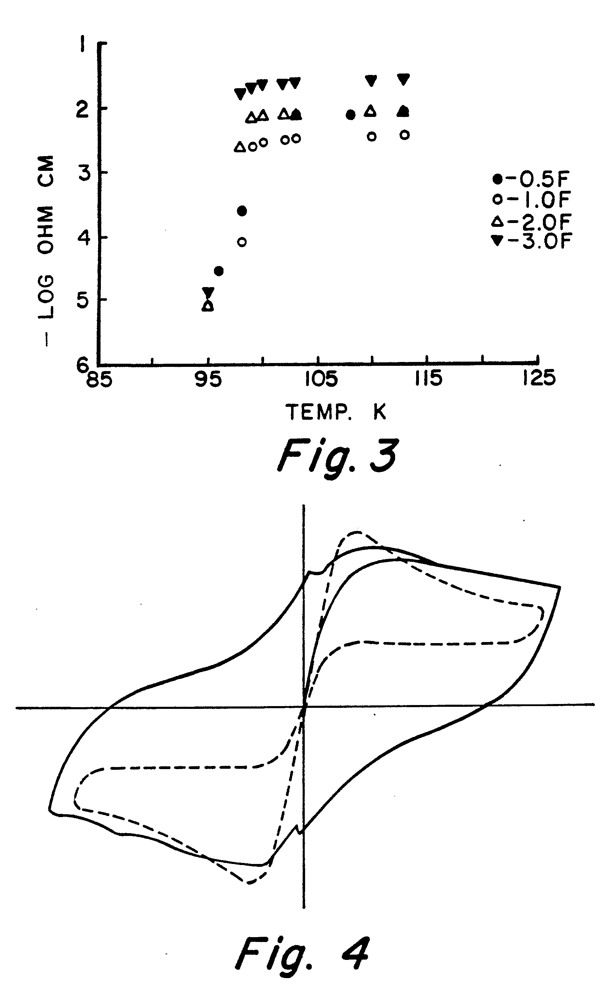

Examples 5, 6, and 7 batched with $BaF_2$ had electrical resistivity behavior as shown in Fig. 2. Of this set of examples, Example 5, $F_{0.5}$, had the lowest normal state electrical resistivity. Examples 1-4 have a similar narrow superconductive temperature range transition as shown in Fig. 3.

Qualitative amounts of second phases related to the 1, 2, 3 phase are shown in Tables VI-IX for Examples 9-13, 5-8, 1-4, and 14-17. The relative heights of the diffraction peaks from the lattice spacings at 2.52 Angstroms for CuO, 3.09 Angstroms for $BaF_2$, and 2.98 Angstroms for what apparently is $Y_2BaCuO_5$, were normalized to the height of the 3.88 Angstrom peak of 1, 2, 3 and are given in these tables.

Table VI shows that even small amounts of fluoride decrease the amount of additional phases over 1,2,3 compositions processed in the same manner up to $F_{0.5}$. Table VI shows that between $F_{0.5}$ and $F_{2.0}$ with materials batched with $BaF_2$ the amounts of additional phases increase dramatically.

Table VII shows that the $F_{1.0}$ composition, when batched with $BaF_2$, can have substantial additional phases. Comparison of Tables VII and VIII shows that less additional phases are found when $YF_3$ is used as the source of fluoride.

Table IX shows that the amounts or additional phases increase as the proportion of $BaF_2$ in the batch increases in the examples where the fluoride is derived from both $YF_3$ and $BaF_2$. As with all of the compositions studied hereunder, all of the mixed composition trends are in agreement with electrical resistivity and magnetic measurements. The optical evaluation of the amount of second phases also agrees with the x-ray diffraction data. The Examples 18-22, in Table IV, were examined optically and the amounts of second phases decrease with increasing fluoride content between $F_{0.05}$ and $F_{0.5}$.

Example 26, $GdBa_2Cu_3O_{7-x}F$, showed the tetragonal phase of gadolinium 1,2,3 as the major phase after sintering. After heat treatment at $500°$ C in oxygen the sample showed superconductivity in the magnetic measurements.

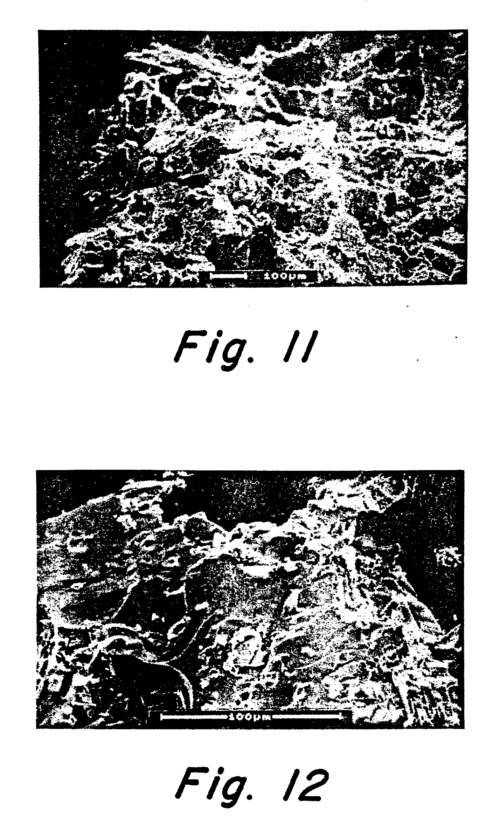

The scanning electron micrographs of Fig. 11 and 12 demonstrate the existence of the large grains produced within bodies prepared using fluorides in the batch. Example 2 was prepared for the SEM pictures of Fig. 11 and 12. The fracture sections exhibit a microstructure which also includes large porosity and inclusions of second phases within the grains.

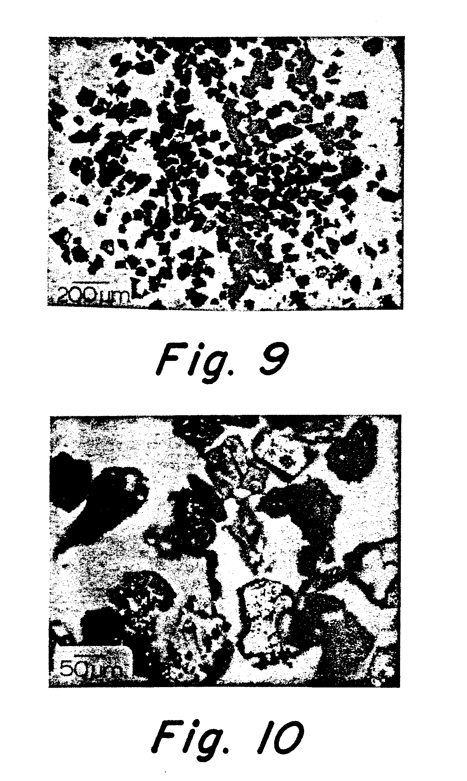

The optical micrographs of Figs. 9 and 10 reveal the high aspect ratio particles which may be derived from these bodies when they are crushed. The highly reflective surfaces seen in Fig. 10 are apparently parallel to the (0K0) crystalline planes. The x-ray diffraction data are consistent with this conclusion.

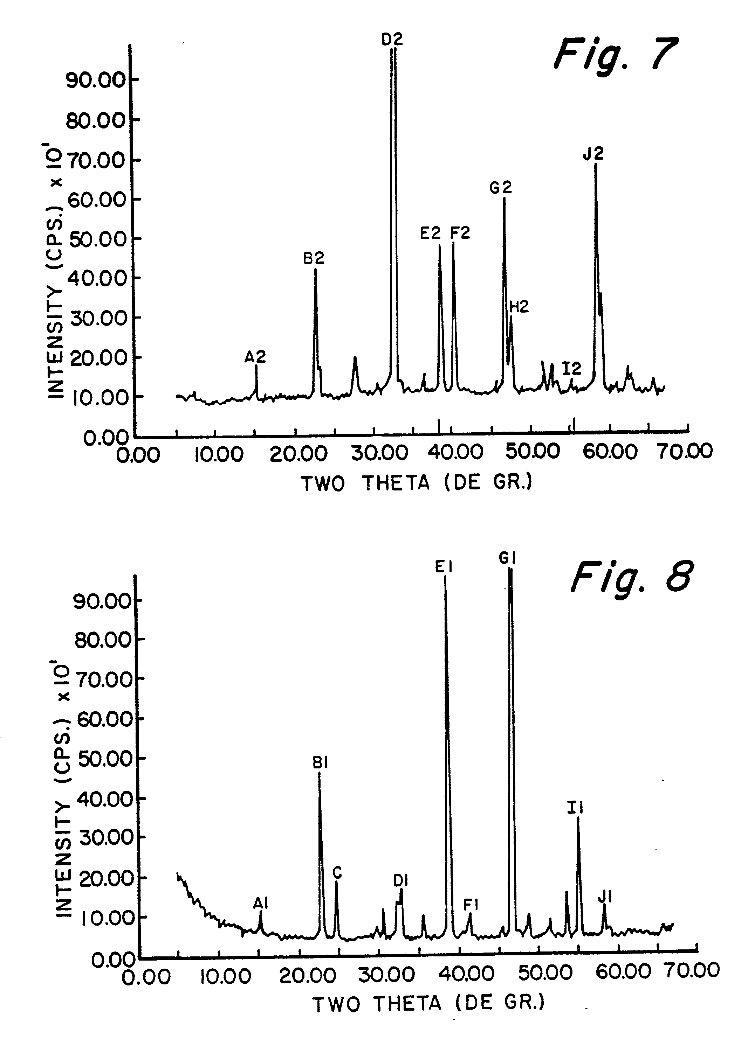

Table XI gives the data and Fig. 8 illustrates the degree of crystallographic orientation achieved by spreading a slurry of the high aspect ratio 1,2,3 particles from Example 27 on a flat substrate. The pattern in Fig. 8 is distinguished from that in Fig. 7. Fig. 7 is x-ray data taken of a nonfluoride containing 1,2,3 superconductor. In Fig. 8, the diffraction lines with miller indices (0K0) are enhanced with respect to all other reflections. The most intense peak in Fig. 7 is $D_2$. $D_2$ corresponds to the mixed reflections 031, 130, and 101. In Fig 8, the corresponding peak, $D_1$, is only 4% of the most intense peak, $G_1$, which has the miller indices 060. The intensity enhancement is attributable to the orientation of the high aspect ratio particles of the substrate.

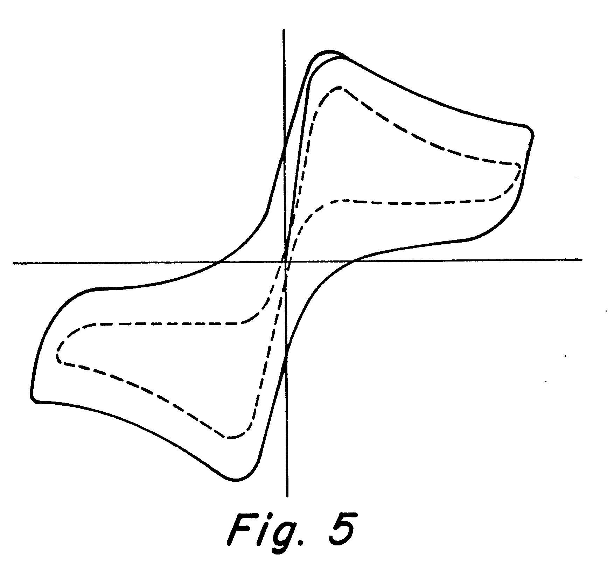

Figs. 4 and 5 exhibit magnetic hysteresis loops for fluoride containing examples. The enhanced widths of the fluoride examples are illustrated with the solid lined loop. A typical nonfluoride hysteresis loop is outlined by the dotted line. The magnitude of the width of the hysteresis is proportional to the current carrying capacity, known also as the critical current by those skilled in the art. The width of the hysteresis loop is a measure of the amount of residual magnetic flux trapped, or pinned, by the example at high applied fields. As the magnitude of the field is decreased the trapped flux opposes the applied field and leads to decreased measured diamagnetism.

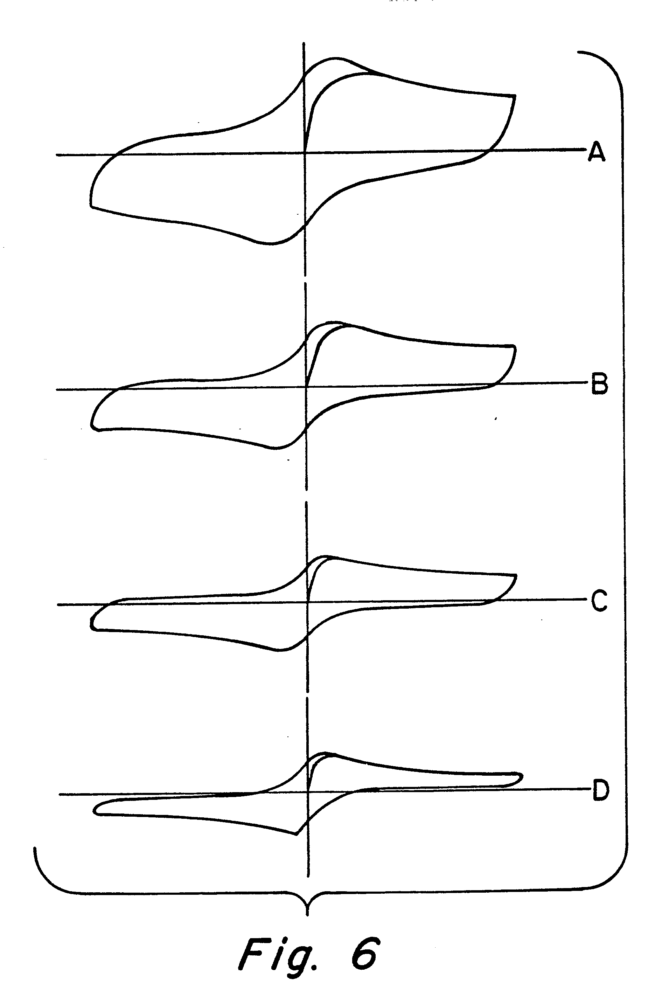

Fig. 6 and Table IX show the magnetic flux and x-ray data, respectively, of the mixed $BaF_2$ and $YF_3$ examples . A nearly linear relationship is seen to exist between the enhancement of properties derived from the increase in the presence of $YF_3$. In Fig. 6, the A magnetic flux measurement has the greatest amount of $YF_3$ and decreases to the least amount in D. It is clear from this data that while $BaF_2$ enhanced 1,2,3 superconductors effect and improved properties, the $YF_3$ enhanced samples are preferred.

Since the current carrying capacity depends upon the amount of flux that is pinned, the wider hysteresis loops for the fluoride containing examples indicate an enhanced current carrying capacity, relative to the nonfluoride containing examples. The capacity of a material to hold a constant current is dependent on pinning in the flux. The enhanced flux pinning could also lead to an improved current stability from a decrease in current losses as a function of flux de-pinning or flux jumping.

When the fluoride containing bodies were lightly ground, fracture occurs to produce high aspect ratio grains. When vigorous grinding ensued the intragranular fracture was enhanced and the high aspect ratio particles were broken up. The poor results from excessive grinding are evidenced in the optical microscope and by a decrease in the magnetic hysteresis. This may be caused by the exposure of the nonsuperconducting inclusions to the surface.

After sintering all fluorides introduced into the 1,2,3 superconductors are associated with barium, regardless of which cation introduces the fluoride. It is speculated that $YF_3$ produces the most preferred embodiment due to the ready donation of fluoride to the barium during the sintering. This may be caused by low melting intermediates which may serve as transient liquid phase sintering aids, enhancing grain growth and second phase inclusions, and possibly leading to the type of fracture which has been observed.

All the above results have been seen in the examples prepared with $BaF_2$ or $CuF_2$; the fluoride effect is optimized under the present conditions with the use of $YF_3$. Tables VII-IX show that less additional phases are found when $YF_3$ is used as the source of fluoride. Examples batched with $YF_3$ exhibit more and faster grain growth than examples batched with other or no fluorides.

$BaF_2$ is formed during sintering when fluorides are added to the batch. If excess barium is added, it is possible to tailor the amount of the second phases that are present to obtain improved properties, such as flux pinning, size, and aspect ratio of the grains. The excess barium may enhance the growth of the large platelets reducing the time required at the sintering temperature. Less than one excess barium atom would be added per two fluorine atoms.

## Claims

1. A 1,2,3 superconductor ceramic body with a nominal composition consisting essentially of $YBa_2Cu_3O_{7-x}F_y$, wherein y equals 0.05 up to 4.0, x equals 0.0 to 0.5, and fluoride is derived from any cationic onstituent of the superconducting body.

2. A 1,2,3 superconductor ceramic body as in claim 1 wherein said fluoride is derived from a rare earth ion selected from the group consisting of Y, La, Nd, Sm, Eu, Gd, Tb, Dy, Ho, Er, Yb, and/or Lu and a combination thereof.

3. A 1,2,3 superconductor ceramic body as in claim 1 wherein said Y may be replaced by any fluoride and combinations of oxides of compounds selected from the group consisting of La, Nd, Sm, Eu, Gd, Tb, Dy, Ho, Er, Yb, and/or Lu and a combination thereof.

4. A 1,2,3 superconductor ceramic body as in claim 1 wherein barium is added in excess of the stoichiometric amount.

5. A 1,2,3 superconductor ceramic body as in claim 1 wherein said fluoride is derived from a rare earth fluoride, copper fluoride, barium fluoride, or a combination thereof.

6. A 1,2,3 superconductor ceramic body as in claim 1 wherein said fluoride is substituted by anions selected from the group consisting of sulfur, halogen and/or a combination thereof.

7. A 1,2,3 superconductor ceramic body as in claim 1 wherein a single or a plurality of large grain platelets are formed ranging in size from 10 to 1000 microns in diameter.

8. A 1,2,3 superconductor ceramic body as in claim 7 wherein said platelets are preferentially oriented.

9. A method of manufacturing the 1,2,3 superconductor according to any of claims 1-8, comprising the steps
   a) mixing compounds of rare earths, barium, copper, and fluorides into a batch,
   b) calcining said batch,
   c) pressing said batch to form a body, and
   d) firing said body into a hardened ceramic body.

10. The method of claim 9 wherein said fluorides are in combination with barium, copper, and/or rare earth cations.

11. A 1,2,3 superconductor ceramic body with a nominal composition consisting essentially of $YBa_2Cu_3O_{7-x}F_y$, wherein y equals 0.05 up to 2.0, x equals 0.0 up to 0.5, and fluoride is derived from $YF_3$.

Fig. 1

Fig. 2

Fig. 3

Fig. 4

Fig. 5

*Fig. 6*

Fig. 7

Fig. 8

Fig. 9

Fig. 10

*Fig. 11*

*Fig. 12*

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | PHYSICAL REVIEW LETTERS, vol. 58, no. 24, 15th June 1987, pages 2579-2581, The American Physical Society, New York, US; S.R. OVSHINSKY et al.: "Superconductivity at 155 K" * Page 2579, right-hand column, paragraph 2 * | 1,4-5,9 -10 | H 01 L 39/12 H 01 L 39/24 |
| X | INORGANIC CHEMISTRY, vol. 27, no. 1, 13th January 1988, pages 5-8, American Chemical Society, Easton, PA, US; H.H. WANG et al.: "Chemical, structural, and electrical property studies on the fluorination of the 90 K superconductor YBa2CuO6.8" * Page 6, table I, right-hand column, paragraph 2; page 7, right-hand column, paragraph 1; page 8, left-hand column, paragraph 2 * | 1-5,8- 11 | |
| P,X | EP-A-0 301 689 (OVONIC) * Page 4, lines 10-32; claims 7,10 * | 1,4-5,9 -10 | TECHNICAL FIELDS SEARCHED (Int. Cl.5) H 01 L 39 |

The present search report has been drawn up for all claims

| Place of search | Date of completion of the search | Examiner |
|---|---|---|
| THE HAGUE | 30-10-1989 | HAMMEL E.J. |

EPO FORM 1503 03.82 (P0401)